# EUROPÄISCHE PATENTSCHRIFT

(11) **EP 2 401 284 B1**
(45) Veröffentlichungstag und Bekanntmachung des Hinweises auf die Patenterteilung: **24.10.2012**
(21) Anmeldenummer: 10704139.4
(22) Anmeldetag: 12.02.2010
(51) Int. Cl.: C07F 7/21

(54) **CYCLISCHE AZA-SILAVERBINDUNGEN**
CYCLIC AZA-SILA COMPOUNDS
COMPOSÉS AZA-SILA CYCLIQUES

(30) Priorität: 26.02.2009 DE 102009001181
(43) Veröffentlichungstag der Anmeldung: 04.01.2012
(73) Patentinhaber: Wacker Chemie AG, 81737 München (DE)
(72) Erfinder: KNIES, Wolfgang, 84489 Burghausen (DE); EIBLMEIER, Hans, 84489 Burghausen (DE)
(74) Vertreter: Fritz, Helmut
(86) Internationale Anmeldenummer: PCT/EP2010/051799
(87) Internationale Veröffentlichungsnummer: WO 2010/097303

(56) Entgegenhaltungen:
- WO-A2-2004/044958
- VEITH MICHAEL ET AL: "Cyclic diazastannylenes. 27. Polycyclic silylamides of germanium(II) and tin(II) with various structures . Bis(germandiyl) versus distannate" ANGEWANDTE CHEMIE, WILEY - V C H VERLAG GMBH & CO. KGAA, WEINHEIM, DE, Bd. 100, Nr. 8, 3. Mai 1988 (1988-05-03), Seiten 1124-1125, XP009131251 ISSN: 0044-8249
- ANDERSCH HELGA ET AL: "Structure of 1,3,5-trimethyl-2,2,4,4,6,6- hexakis(methylamino)cyclotr isilazane" ACTA CRYSTALLOGRAPHICA SECTION C. CRYSTAL STRUCTURE COMMUNICATIONS, MUNKSGAARD, COPENHAGEN, DK, Bd. C46, Nr. 6, 25. Januar 1990 (1990-01-25), Seiten 1180-1181, XP009131252 ISSN: 0108-2701

## Beschreibung

Die Erfindung betrifft cyclische Aza-Silaverbindungen, die aufgebaut sind aus 4 bis 10 über Si-Si oder Si-N Einfachbindungen verbundenen Einheiten und deren Herstellung.

Aminosilan-Verbindungen sind für die Herstellung von Si-N- und Si-O-Schichten von großem Interesse. Aminosubstituierte Monosilane sind hierfür schon untersucht wurden, auch einige Disilane zeigen gute Eigenschaften. Insofern besteht ein Interesse an Verbindungen mit hohem Siliziumgehalt. Von besonderem Interesse sind die noch nicht beschriebenen Cyclen mit hohem Siliziumgehalt infolge benachbarter Si-Atome.

US 3565934 beschreibt die Thermolyse von Aminosilanen, bei der 1,3-Diaza-Disila-Cyclobutane entstehen. Begünstigt wird diese Reaktion durch Aminchloridreste. Ammoniumsalze führen zu einer Abspaltung von Amin aus dem Aminosilan.

In WO 2004/044958 ist die Herstellung eines 1,3-Diaza-Disila-Cyclobutans aus einem Aminochlorsilan mit tert. Butyllithium beschrieben.

Gegenstand der Erfindung sind cyclische Aza-Silaverbindungen, die aufgebaut sind aus 4 bis 10 über Si-Si oder Si-N Einfachbindungen verbundenen Einheiten der allgemeinen Formeln (I) und (II)

=SiY₂ (I),

=NR³ (II),

wobei
- **Y**: ausgewählt wird aus **-NR¹R²**, Wasserstoff und Halogen,
- **R¹** und **R²**: ausgewählt werden aus Wasserstoff und Kohlenwasserstoffrest mit 1 bis 20 Kohlenstoffatomen und
- **R³**: Kohlenwasserstoffrest mit 1 bis 20 Kohlenstoffatomen bedeuten,

mit der Maßgabe, dass im Ring mindestens zwei Einheiten der allgemeinen Formeln (I) über eine Si-Si Einfachbindung miteinander verbunden sind,
dass höchstens 35 Mol-% der Reste **Y** Wasserstoff bedeuten und höchstens 15 Mol-% der Reste **Y** Halogen bedeuten.

Die cyclischen Aza-Silaverbindungen sind verdampfbar und deshalb für die Herstellung von Si-N- und Si-O-Schichten hervorragend geeignet.

**R¹**, **R²** und **R³** sind vorzugsweise lineare oder verzweigte Alkyl-, Cycloalkyl-, Aryl-, Alkenyl- oder Arylalkylreste, bevorzugt Alkylreste. Bevorzugt weisen die Reste **R¹**, **R²** und **R³** 1 bis 12, insbesondere 1 bis 6 Kohlenstoffatome auf. Besonders bevorzugte Reste **R¹**, **R²** und **R³** sind Methyl-, Ethyl-, n-Propyl-, isoPropyl-, n-Butyl-, iso-Butyl-, tert.-Butyl-, n-Pentyl-, isoPentyl-, neo-Pentyl- oder tert.-Pentylrest und Phenylrest.

In der allgemeinen Formel (I) bedeuten vorzugsweise höchstens 20 Mol-%, besonders bevorzugt höchstens 10 Mol-%, insbesondere keine der Reste **Y** Wasserstoff. Wenn **Y** Halogen bedeutet, sind Brom und Iod und insbesondere Chlor bevorzugt.

In der allgemeinen Formel (I) bedeuten vorzugsweise höchstens 1 Mol-%, besonders bevorzugt höchstens 0,1 Mol-%, insbesondere höchstens 0,01 Mol-%, insbesondere bevorzugt keine der Reste **Y** Halogen.

Vorzugsweise bedeutet **Y** den Rest -NH**R²**. Vorzugsweise hat **R²** die gleiche Bedeutung wie **R³**.

Vorzugsweise sind die cyclischen Aza-Silaverbindungen aufgebaut aus 4, 6 oder 10 Einheiten der allgemeinen Formeln (I) und (II). Besonders bevorzugt sind cyclische Aza-Silaverbindungen, die aufgebaut sind aus 3 oder 4 Einheiten der allgemeinen Formel (I) und 1 oder 2 Einheiten der allgemeinen Formel (II).

Besonders bevorzugte cyclische Aza-Silaverbindungen sind die 1-Aza-2,3,4-Trisila-Cyclobutane, insbesondere die 1-Alkyl-2,2,3,3,4,4-Hexakisalkylamino-1-Aza-2,3,4-Trisila-Cyclobutane und die 1,4-Diaza-2,3,5,6- Tetrasila-Cyclohexane, insbesondere die 1,4-Dialkyl-2,2,3,3,5,5,6,6-Oktakisalkylamino-1,4-Diaza-2,3,5,6-Tetrasila-Cyclohexane.

Die cyclischen Aza-Silaverbindungen können hergestellt werden durch Umsetzung von linearen Oligosilanen der allgemeinen Formel (III)

Y (SiY₂)ₘSiY₃ (III),

mit Aminsalzen der allgemeinen Formel (IV)

X(H₂NR³) (IV),

wobei
- **X**: ein Halogenatom und
- **m**: die Werte 1, 2 oder 3 bedeuten und
- **R³** und **Y**: die vorstehenden Bedeutungen aufweisen.

Zur Steuerung der Ringgrösse werden die eingesetzten Verhältnisse der Oligosilane der allgemeinen Formel (III) und der Aminsalze der allgemeinen Formel (IV) gewählt.

Vorzugsweise bedeutet **X** ein Chloratom.

Vorzugsweise wird Aminsalz der allgemeinen Formel (IV) im Unterschuss gegenüber dem linearen Oligosilan der allgemeinen Formel (III) eingesetzt.

Vorzugsweise sind bei der Umsetzung mindestens 0,1 Gew.-%, besonders bevorzugt mindestens 1 Gew.-% Aminsalz der allgemeinen Formel (IV) bezogen auf die linearen Oligosilane der allgemeinen Formel (III) anwesend.

Vorzugsweise beträgt die Temperatur der Umsetzung mindestens 20°C, besonders bevorzugt mindestens 50°C und vorzugsweise höchstens 200°C, besonders bevorzugt höchstens 150°C. Die obere Temperaturgrenze richtet sich bevorzugt nach dem Siedepunkt der eingesetzten Verbindungen.

Das Verfahren kann in einem Lösemittel, insbesondere unpolaren Lösemittel durchgeführt werden. Bevorzugt sind Kohlenwasserstoffe und halogenierte Kohlenwasserstoffe. Lösemittel-Gemische mit einem Siedepunkt bzw. Siedebereich von bis zu 150°C bei 1 bar sind bevorzugt. Beispiele für solche Lösemittel sind die Alkane mit 3 bis 10 Kohlenstoffatomen, Aromaten mit 6 bis 12 Kohlenstoffatomen, halogenierte Alkane mit 1 bis 3 Kohlenstoffatomen und deren Gemische. Bevorzugte Beispiele sind Dichlormethan, Tetrachlormethan, Butan, Pentan, Hexan, Heptan, Oktan, Benzol, Toluol und Xylole und deren Isomerengemische.

Der Fortschritt der Reaktion kann an der Bildung von freiem Amin verfolgt werden.

Die cyclischen Aza-Silaverbindungen können auch hergestellt werden durch Erwärmen von linearen Oligosilanen der allgemeinen Formel (III)

Y(SiY₂)ₘSiY₃ (III),

wobei
- **m**: die Werte 1, 2 oder 3 bedeuten und
- **Y**: die vorstehenden Bedeutungen aufweist.

Die linearen Oligosilane der allgemeinen Formel (III) können bei diesem lierstellungsverfahren disproportionieren.

Vorzugsweise beträgt die Temperatur der Umsetzung mindestens 80°C, besonders bevorzugt mindestens 120°C und vorzugsweise höchstens 250°C, besonders bevorzugt höchstens 200°C. Die obere Temperaturgrenze richtet sich bevorzugt nach dem Siedepunkt der eingesetzten Verbindungen.

Die Umsetzung findet vorzugsweise in Gegenwart von Lewis-Basen statt. Beispiele für Basen sind Hydroxide, wie Alkali- und Erdalkalihydroxide, insbesondere LiOH, NaOH, KOH, RbOH, CsOH, Mg(OH)₂, Ca(OH)₂, Sr(OH)₂, Ba(OH)₂, Ammoniak, Amine, Amide, wie Natrium- und Kaliumamid, Silazide, wie Lithiumsilazid, Hydride, wie Natrium-, Kalium- und Kalziumhydrid, Alkoholate, wie Isopropylat, Ethanolat und Methanolat. Bevorzugte Basen sind Amine, insbesondere primäre und sekundäre Amine, und Silazide, wie Lithiumsilazid.

Vorzugsweise sind bei der Umsetzung mindestens 0,1 Gew.-%, besonders bevorzugt mindestens 1 Gew.-% Base bezogen auf die linearen Oligosilane der allgemeinen Formel (III) anwesend.

In einer besonderen Ausführungsform wirken die bei der Umsetzung entstehenden Amine als Katalysator. Vorzugsweise werden die Amine daran gehindert, aus dem Reaktionsgemisch zu entweichen. Dies geschieht vorzugsweise durch Erhöhen des Drucks.

Das Verfahren kann in einem Lösemittel, insbesondere unpolaren Lösemittel durchgeführt werden. Bevorzugt sind die vorstehend genannten Lösemittel, wobei auch höher siedende Lösemittel bevorzugt sind.

Alle vorstehenden Symbole der vorstehenden Formeln weisen ihre Bedeutungen jeweils unabhängig voneinander auf.

In den folgenden Beispielen sind, falls jeweils nicht anders angegeben, alle Mengen- und Prozentangaben auf das Gewicht bezogen, alle Drücke 1 bar (abs.) und alle Temperaturen 20°C.

### Beispiel 1: Herstellung von 1,4-Diethyl-2,2,3,3,5,5,6,6-Oktakisethylamino-1,4-Diaza-2,3,5,6-Tetrasila-Cyclohexan

38 g Hexakisethylamino-Disilan mit einer Reinheit von 98 % wurden mit 1,3 Gew.-% Ethylaminhydrochlorid versetzt und 7 Stunden am Rückfluss erhitzt. Die Temperatur stieg kurz auf 135°C und fiel nach wenigen Minuten auf 115°C. Es entstanden 9 g 1,4-Diethyl-2,2,3,3,5,5,6,6-Oktakisethylamino-1,4-Diaza-2,3,5,6-Tetrasila-Cyclohexan.

Beim Verwendung von 7 Gew.-% Ethylaminhydrochlorid entstanden unter gleichen Reaktionsbedingungen aus 40g Hexakisethylamin-Disilan 18 g 1,4-Diethyl-2,2,3,3,5,5,6,6-Oktakisethylamino-1,4-Diaza-2,3,5,6-Tetrasila-Cyclohexan.

### Beispiel 2: Herstellung von 1-Ethyl-2,2,3,3,4,4-Hexakisethylamino-1-Aza-2,3,4-Trisila-Cyclobutan

Beim Erhitzen von 40 g Hexakisethylaminodisilan in einem Glaskolben mit Rückflusskühler bei 150°C unter fließendem Stickstoff entstand nach 35h ein Gemisch von 25 g Tetrakisethylaminosilan und 2 g 1-Ethyl-2,2,3,3,4,4-Hexakisethylamino-1-Aza-2,3,4-Trisila-Cyclobutan. 1,4-Diethyl-2,2,3,3,5,5,6,6-Oktakisethylamino-1,4-Diaza-2,3,5,6-Tetrasila-Cyclohexan war nur in Spuren nachweisbar. Im Gegensatz zu Beispiel 1 blieb die Temperatur konstant bei 150°C.

### Beispiel 3: Herstellung von 1-Ethyl-2,2,3,3,4,4-Hexakisethylamino-1-Aza-2,3,4-Trisila-Cyclobutan

In ein Stahlrohr, das an beiden Enden druckfest verschraubt war, wurden 4 g Hexakisethylaminodisilan gegeben. Das Rohr wurde 5 Tage auf 150°C erhitzt. Neben unzersetztem Ausgangsprodukt wurden 4 Gew.-% Oktakisethylamino-Trisilan und 11 Gew.-% 1-Ethyl-2,2,3,3,4,4-Hexakisethylamino-1-Aza-2,3,4-Trisila-Cyclobutan gefunden. Die Probe enthielt 9 Gew.-% Ethylamin, das im Gegensatz zu Beispiel 1 und 2 nicht entweichen konnte.

## Patentansprüche

1. Cyclische Aza-Silaverbindungen, die aufgebaut sind aus 3 oder 4 Einheiten der allgemeinen Formel (I) und 1 oder 2 Einheiten der allgemeinen Formel (II), wobei die Einheiten über Si-Si oder Si-N Einfachbindungen verbunden sind
=SiY₂ (I),
=NR³ (II),
wobei
**Y** ausgewählt wird aus **-NR¹R²**, Wasserstoff und Halogen,
**R¹** und **R²** ausgewählt werden aus Wasserstoff und Kohlenwasserstoffrest mit 1 bis 20 Kohlenstoffatomen und
**R³** Kohlenwasserstoffrest mit 1 bis 20 Kohlenstoffatomen bedeuten,
mit der Maßgabe, dass im Ring mindestens zwei Einheiten der allgemeinen Formeln (I) über eine Si-Si Einfachbindung miteinander verbunden sind,
dass höchstens 35 Mol-% der Reste Y Wasserstoff bedeuten und
höchstens 15 Mol-% der Reste Y Halogen bedeuten.

2. Cyclische Aza-Silaverbindungen nach Anspruch 1, bei denen **R¹**, **R²** und **R³** Alkylreste sind.

3. Cyclische Aza-Silaverbindungen nach Anspruch 1 oder 2, bei denen **Y** den Rest -NH**R²** bedeutet.

4. Cyclische Aza-Silaverbindungen nach Anspruch 1 bis 3, welche ausgewählt werden aus 1-Aza-2,3,4-Trisila-Cyclobutanen und 1,4-Diaza-2,3,5,6- Tetrasila-Cyclohexanen.

5. Verfahren zur Herstellung von cyclischen Aza-Silaverbindungen, die aufgebaut sind aus 3 oder 4 Einheiten der allgemeinen Formel (I) und 1 oder 2 Einheiten der allgemeinen Formel (II), wobei die Einheiten über Si-Si oder Si-N Einfachbindungen verbunden sind
=SiY₂ (I),
=NR³ (II),
wobei
**Y** ausgewählt wird aus -N**R¹R²**, Wasserstoff und Halogen,
**R¹** und **R²** ausgewählt werden aus Wasserstoff und Kohlenwasserstoffrest mit 1 bis 20 Kohlenstoffatomen und
**R³** Kohlenwasserstoffrest mit 1 bis 20 Kohlenstoffatomen bedeuten,
mit der Maßgabe, dass im Ring mindestens zwei Einheiten der allgemeinen Formeln (I) über eine Si-Si Einfachbindung miteinander verbunden sind,
dass höchstens 35 Mol-% der Reste **Y** Wasserstoff bedeuten und
höchstens 15 Mol-% der Reste **Y** Halogen bedeuten,
bei dem lineare Oligosilane der allgemeinen Formel (III)
Y(SiY₂)ₘSiY₃ (III),
mit Aminsalzen der allgemeinen Formel (IV)
X(H₂NR³) (IV),
umgesetzt werden, wobei
**X** ein Halogenatom und
**m** die Werte 1, 2 oder 3 bedeuten und
**R³** und **Y** die vorstehenden Bedeutungen aufweisen.

6. Verfahren nach Anspruch 5, bei dem **X** ein Chloratom bedeutet.

7. Verfahren zur Herstellung von cyclischen Aza-Silaverbindungen, die aufgebaut sind aus 3 oder 4 Einheiten der allgemeinen Formel (I) und 1 oder 2 Einheiten der allgemeinen Formel (II), wobei die Einheiten über Si-Si oder Si-N Einfachbindungen verbunden sind
=SiY₂ (I),
=NR³ (II),
**wobei**
**Y** ausgewählt wird aus -N**R¹R²**, Wasserstoff und Halogen,
**R¹** und **R²** ausgewählt werden aus Wasserstoff und Kohlenwasserstoffrest mit 1 bis 20 Kohlenstoffatomen und
**R³** Kohlenwasserstoffrest mit 1 bis 20 Kohlenstoffatomen bedeuten,
mit der Maßgabe, dass im Ring mindestens zwei Einheiten der allgemeinen Formeln (I) über eine Si-Si Einfachbindung miteinander verbunden sind,
dass höchstens 35 Mol-% der Reste **Y** Wasserstoff bedeuten und
höchstens 15 Mol-% der Reste **Y** Halogen bedeuten, bei dem lineare Oligosilanen der allgemeinen Formel (III)
Y(SiY₂)ₘSiY₃ (III),
erwärmt werden, wobei
**m** die Werte 1, 2 oder 3 bedeuten und
**Y** die vorstehenden Bedeutungen aufweist.

8. Verfahren nach Anspruch 7, bei dem die Temperatur der Umsetzung mindestens 80°C beträgt.

9. Verfahren nach Anspruch 7 oder 8, bei dem die Umsetzung in Gegenwart von Base stattfindet.

10. Verfahren nach Anspruch 9, bei dem die Base ein Amin ist.

11. Verfahren nach Anspruch 5 bis 10, bei dem Lösemittel verwendet werden.

## Claims

1. Cyclic aza-sila compounds formed from 3 or 4 units of the general formula (I) and 1 or 2 units of the general formula (II), where the units are bonded via Si-Si or Si-N single bonds,
=SiY₂ (I)
=NR³ (II)
where
**Y** is selected from **-NR¹R²**, hydrogen and halogen,
**R¹** and **R²** are selected from hydrogen and hydrocarbyl radical having 1 to 20 carbon atoms and
**R³** is a hydrocarbyl radical having 1 to 20 carbon atoms,
with the proviso that at least two units of the general formula (I) in the ring are bonded to one another via an Si-Si single bond,
that at most 35 mol% of the **Y** radicals are hydrogen and
at most 15 mol% of the **Y** radicals are halogen.

2. Cyclic aza-sila compounds according to Claim 1, in which **R¹**, **R²** and **R³** are each alkyl radicals.

3. Cyclic aza-sila compounds according to Claim 1 or 2, in which **Y** is the -NH**R²** radical.

4. Cyclic aza-sila compounds according to Claims 1 to 3, which are selected from 1-aza-2,3,4-trisilacyclobutanes and 1,4-diaza-2,3,5,6-tetrasilacyclohexanes.

5. Process for preparing cyclic aza-sila compounds formed from 3 or 4 units of the general formula (I) and 1 or 2 units of the general formula (II), where the units are bonded via Si-Si or Si-N single bonds
=SiY₂ (I)
=NR³ (II)
where
**Y** is selected from **-NR¹R²**, hydrogen and halogen,
**R¹** and **R²** are selected from hydrogen and hydrocarbyl radical having 1 to 20 carbon atoms and
**R³ is** a hydrocarbyl radical having 1 to 20 carbon atoms,
with the proviso that at least two units of the general formula (I) in the ring are bonded to one another via an Si-Si single bond,
that at most 35 mol% of the **Y** radicals are hydrogen and
at most 15 mol% of the **Y** radicals are halogen,
in which linear oligosilanes of the general formula (III)
Y(SiY₂)ₘSiY₃ (III)
are reacted with amine salts of the general formula (IV)
X(H₂NR³) (IV)
where
**X** is a halogen atom and
**m** has the values of 1, 2 or 3 and
**R³** and **Y** are each as defined above.

6. Process according to Claim 5, in which **X** is a chlorine atom.

7. Process for preparing cyclic aza-sila compounds formed from 3 or 4 units of the general formula (I) and 1 or 2 units of the general formula (II), where the units are bonded via Si-Si or Si-N single bonds
=SiY₂ (I)
=NR³ (II)
where
**Y** is selected from **-NR¹R²**, hydrogen and halogen,
**R¹** and **R²** are selected from hydrogen and hydrocarbyl radical having 1 to 20 carbon atoms and
**R³** is a hydrocarbyl radical having 1 to 20 carbon atoms,
with the proviso that at least two units of the general formula (I) in the ring are bonded to one another via an Si-Si single bond,
that at most 35 mol% of the **Y** radicals are hydrogen and
at most 15 mol% of the **Y** radicals are halogen, in which linear oligosilanes of the general formula (III)
Y(SiY₂)ₘSiY₃ (III)
are heated, where
**m** has the values of 1, 2 or 3, and
**Y** is as defined above.

8. Process according to Claim 7, in which the reaction temperature is at least 80°C.

9. Process according to Claim 7 or 8, in which the reaction takes place in the presence of base.

10. Process according to Claim 9, in which the base is an amine.

11. Process according to Claims 5 to 10, in which solvents are used.

## Revendications

1. Composés aza-sila cycliques, qui sont formés de 3 ou 4 unités de formule générale (I) et 1 ou 2 unités de formule générale (II), les unités étant reliées par des liaisons simples Si-Si ou Si-N
=SiY₂ (I)
=NR³ (II)
Y étant choisi parmi -NR¹R², hydrogène et halogène,
R¹ et R² étant choisis parmi hydrogène et un radical hydrocarboné de 1 à 20 atomes de carbone et
R³ signifiant un radical hydrocarboné de 1 à 20 atomes de carbone,
à condition qu'au moins deux unités de formule générale (I) soient reliées les unes aux autres par une liaison simple Si-Si dans le cycle,
qu'au plus 35 % en moles des radicaux Y signifient hydrogène et
qu'au plus 15 % en moles des radicaux Y signifient halogène.

2. Composés aza-sila cycliques selon la revendication 1, dans lesquels R¹, R² et R³ sont des radicaux alkyle.

3. Composés aza-sila cycliques selon la revendication 1 ou 2, dans lesquels Y signifie le radical -NHR².

4. Composés aza-sila cycliques selon les revendications 1 à 3, qui sont choisis parmi les 1-aza-2,3,4-trisila-cyclobutanes et les 1,4-diaza-2,3,5,6-tétrasila-cyclohexanes.

5. Procédé de fabrication de composés aza-sila cycliques, qui sont formés de 3 ou 4 unités de formule générale (I) et 1 ou 2 unités de formule générale (II), les unités étant reliées par des liaisons simples Si-Si ou Si-N
=SiY₂ (I)
=NR³ (II)
Y étant choisi parmi -NR¹R², hydrogène et halogène,
R¹ et R² étant choisis parmi hydrogène et un radical hydrocarboné de 1 à 20 atomes de carbone et
R³ signifiant un radical hydrocarboné de 1 à 20 atomes de carbone,
à condition qu'au moins deux unités de formule générale (I) soient reliées les unes aux autres par une liaison simple Si-Si dans le cycle,
qu'au plus 35 % en moles des radicaux Y signifient hydrogène et
qu'au plus 15 % en moles des radicaux Y signifient halogène,
dans lequel des oligosilanes linéaires de formule générale (III)
Y(SiY₂)ₘSiY₃ (III)
sont mis en réaction avec des sels d'amine de formule générale (IV)
X (H₂NR³) (IV)
X signifiant un atome d'halogène et
m signifiant les valeurs 1, 2 ou 3 et
R³ et Y présentant les significations précédentes.

6. Procédé selon la revendication 5, dans lequel X signifie un atome de chlore.

7. Procédé de fabrication de composés aza-sila cycliques, qui sont formés de 3 ou 4 unités de formule générale (I) et 1 ou 2 unités de formule générale (II), les unités étant reliées par des liaisons simples Si-Si ou Si-N
=SiY₂ (I)
=NR³ (II)
Y étant choisi parmi -NR¹R², hydrogène et halogène,
R¹ et R² étant choisis parmi hydrogène et un radical hydrocarboné de 1 à 20 atomes de carbone et
R³ signifiant un radical hydrocarboné de 1 à 20 atomes de carbone,
à condition qu'au moins deux unités de formule générale (I) soient reliées les unes aux autres par une liaison simple Si-Si dans le cycle,
qu'au plus 35 % en moles des radicaux Y signifient hydrogène et
qu'au plus 15 % en moles des radicaux Y signifient halogène,
dans lequel des oligosilanes linéaires de formule générale (III)
Y(SiY₂)ₘSiY₃ (III)
sont chauffés,
m signifiant les valeurs 1, 2 ou 3 et
Y présentant les significations précédentes.

8. Procédé selon la revendication 7, dans lequel la température de la réaction est d'au moins 80 °C.

9. Procédé selon la revendication 7 ou 8, dans lequel la réaction a lieu en présence d'une base.

10. Procédé selon la revendication 9, dans lequel la base est une amine.

11. Procédé selon les revendications 5 à 10, dans lequel des solvants sont utilisés.
